# EUROPÄISCHE PATENTSCHRIFT

(11) **EP 2 109 778 B1**
(45) Veröffentlichungstag und Bekanntmachung des Hinweises auf die Patenterteilung: **15.08.2012**
(21) Anmeldenummer: 08707039.7
(22) Anmeldetag: 15.01.2008
(51) Int. Cl.: G01R 31/316, H03F 3/72, H03G 3/12

(54) **Verstärker-Schaltungsanordnung mit integrierter Testschaltung**
Amplification circuit having an integrated test circuit
Circuit d'amplificateur à circuit de test intégré

(30) Priorität: 16.01.2007 DE 202007000891 U
(43) Veröffentlichungstag der Anmeldung: 21.10.2009
(73) Patentinhaber: IC-Haus Gmbh, 55294 Bodenheim (DE)
(72) Erfinder: KRACK, Bernhard, 55299 Nackenheim (DE); HERZ, Manfred, D-55130 Mainz (DE)
(74) Vertreter: Kampfenkel, Klaus
(86) Internationale Anmeldenummer: PCT/EP2008/000235
(87) Internationale Veröffentlichungsnummer: WO 2008/086997

(56) Entgegenhaltungen:
- WO-A-2005/036733
- DE-A1- 19 630 393
- FR-A- 2 129 989
- US-A- 3 581 198
- US-A- 4 274 056
- US-A- 4 509 021
- US-A- 6 069 533
- YAMATAKE, M.: "A Simplified Test Set for OP AMP Characterization"[Online] April 1986 (1986-04), Seiten 1-10, XP002482266 Gefunden im Internet: URL:http://www.national.com/an/AN/AN-24.pd f> [gefunden am 2008-05-30]

## Beschreibung

Die Erfindung betrifft im Allgemeinen eine integrierte Schaltungsanordnung, die einen Präzisions-Operationsverstärker mit sehr niedriger Offsetspannung enthält, und insbesondere eine Verstärkerschaltungsanordnung mit integrierter Testschaltung.

Operationsverstärker, die als integrierte Schaltungen hergestellt werden, sind hinlänglich bekannt. Operationsverstärker sind gewöhnlich in Standard-Plastikgehäusen untergebracht, wobei die Ausgangs- und Eingangsanschlüsse des Operationsverstärkers über Pins herausgeführt sind. Beim Testen der elektrischen Eigenschaften eines Operationsverstärkers wird das Prüfgerät an die entsprechenden Pins des Gehäuses angeschlossen. In der Regel wird ein Operationsverstärker hoher Präzision beispielsweise hinsichtlich der Offsetspannung, der Gleichtaktunterdrückung, der Betriebsspannungs-Unterdrückung oder seines Verhaltens im belasteten Zustand spezifiziert und geprüft. Unter Offsetspannung versteht man die Spannungsdifferenz, die an den Eingängen des Operationsverstärkers anliegen muss, damit die Ausgangsspannung Null wird.

Yamatake, M., "A Simplified Test Set for OP AMP Characterization", April 1986, Seiten 1-10, (http://www.national.com/an/AN/AN-24.pdf) beschreibt eine Testschaltung zur Bestimmung von DC-Parametern eines Operationsverstärkers.

Aufgrund der unterschiedlichen Materialien der Pins und der Kontaktelemente des Prüfgerätes entstehen an den Pins Kontaktspannungen, die im Mikrovoltbereich liegen können.

Bei einem Operationsverstärker hoher Präzision liegt dessen Offsetspannung ebenfalls im Mikrovoltbereich, so dass infolge der relativ hohen Kontaktspannungen die elektrischen Eigenschaften, insbesondere die Offsetspannung des Operationsverstärkers hoher Präzision, nicht mehr geprüft werden.können.

Der vorliegenden Erfindung liegt demzufolge die Aufgabe zugrunde, eine integrierte Verstärker-Schaltungsanordnung bereitzustellen, die insbesondere auch bei Einsatz eines Operationsverstärkers hoher Präzision, d. h. mit Offsetspannungen im Mikrovoltbereich, getestet werden kann.

Dieses technische Problem löst die Erfindung durch eine in Anspruch 1 definierte integrierte Schaltungsanordnung, bei der wenigstens ein Operationsverstärker und ein dem Operationsverstärker zugeordnetes Gegenkopplungsnetzwerk integriert hergestellt werden. Ferner können integrierte Schalter, beispielsweise in Form von Feldeffekttransistoren, vorgesehen sein, über die der Operationsverstärker während einer durchzuführenden Testphase mit dem Gegenkopplungsnetzwerk verbunden werden kann. Das Gegenkopplungsnetzwerk sorgt dafür, dass die Offsetspannung des Operationsverstärkers um einen ausreichend hohen Betrag verstärkt wird.

Gemäß einer bevorzugten Ausführungsform enthält das Gegenkopplungsnetzwerk einen Spannungsteiler.

Ein weiteres vorteilhaftes Ausführungsbeispiel sieht vor, das Gegenkopplungsnetzwerk durch mehrere hintereinander geschaltete Spannungsteiler aufzubauen.

Bei dem Spannungsteiler handelt es sich vorzugsweise um ein passives, aus Widerständen aufgebautes Netzwerk.

Um eine ausreichende Verstärkung der Offsetspannung des Operationsverstärkers zu erreichen, sind beispielsweise sechs Spannungsteiler hintereinander geschaltet, wobei die Komponenten der Spannungsteiler derart bemessen sind, dass sich ein Gegenkopplungsfaktor von 10⁶ ergibt. In diesem Fall kann jeder der sechs Spannungsteiler ein Verhältnis von 10 : 1 auf, so dass sich der Gegenkopplungsfaktor von 10⁶ ergibt.

Die Erfindung wird nachfolgend anhand zweier Ausführungsbeispiele in Verbindung mit den beiliegenden Zeichnungen näher erläutert. Es zeigen:
- Fig. 1: eine monolithisch integrierte VerstärkerSchaltungsanordnung gemäß der Erfindung, wobei das Gegenkopplungsnetzwerk einen einzigen Spannungsteiler enthält, und
- Fig. 2: eine alternative monolithisch integrierte Verstärker-Schaltungsanordnung gemäß der Erfindung, wobei das Gegenkopplungsnetzwerk sechs hintereinander geschaltete Spannungsteiler aufweist.

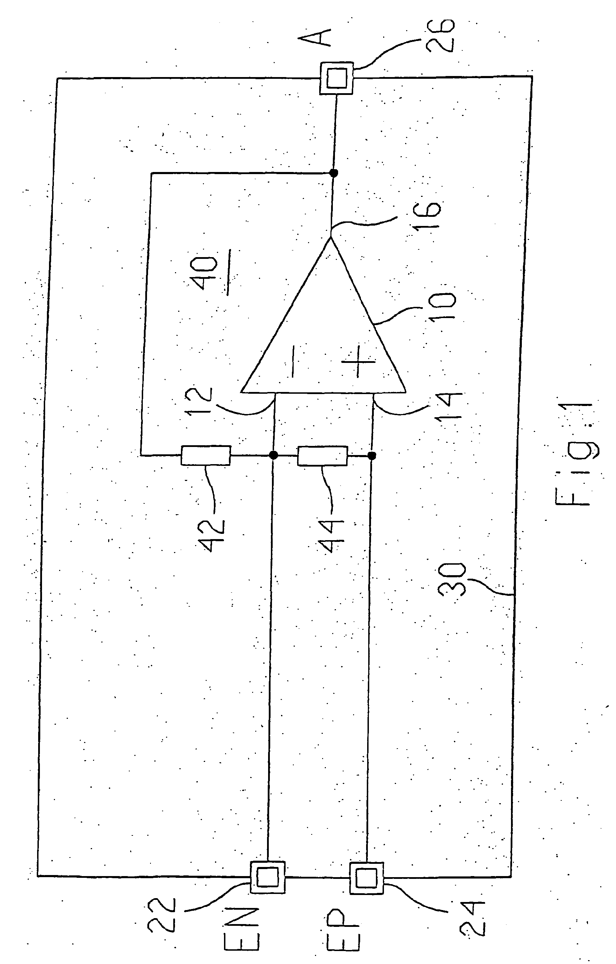

Fig. 1 zeigt einen herkömmlichen Präzisions-Operationsverstärker 10 mit sehr guten elektrischen Eigenschaften. Beispielsweise liegt die Offsetspannung eines solchen Operationsverstärkers im Mikrovoltbereich. Der Operationsverstärker 10 weist einen invertierenden Eingang 12, einen nicht invertierenden Eingang 14 sowie einen Ausgang 16 aufweist. Wie in Fig. 1 schematisch und beispielhaft dargestellt, ist der Operationsverstärker 10 in einem mehrere Pins aufweisenden Standard-Plastikgehäuse 30 angeordnet. Der nicht invertierende Eingang 14 ist beispielsweise mit dem Pin 24 des Gehäuses 30 verbunden ist, der invertierende Eingang 12 ist mit dem Pin 22 verbunden, und der Ausgang 16 des Operationsverstärkers 10 ist mit dem Pin 26 des Gehäuses 30 verbunden. Das Gehäuse 30 weist in üblicher Weise weitere Pins auf, an die beispielsweise die Betriebsspannungen für den Operationsverstärker 10 und/oder die Anschlüsse weiterer Operationsverstärker angeschlossen werden können. Der Operationsverstärker 10 ist über nicht dargestellte Schalter mit einem Gegenkopplungsnetzwerk 40 verbunden, welches einen einzigen Spannungsteiler aufweist. Der Spannungsteiler ist schematisch durch zwei Widerstände 42. und 44 dargestellt. Der Widerstand 42 des Spannungsteilers 40 an den invertierenden Eingang 12 und den Ausgang 16 des Operationsverstärkers angeschlossen. Der zweite Widerstand 44 ist mit dem invertierenden und dem nicht invertierenden Eingang 14 verbunden. Soll vorzugsweise mit der in Fig. 1 gezeigten Schaltungsanordnung ein Gegenkopplungsfaktor von 10⁶ zu erzielt werden, müssen aus praktischen Gesichtspunkten mehr als 600 Widerstände verwendet werden. Mit anderen Worten umfassen die symbolisch dargestellten Widerstände 42 und 44 jeweils etwa 300 einzelne, in Reihe oder parallel geschaltete Widerstände. Der Operationsverstärker 10 und das Gegenkopplungsnetzwerk 40 bilden zusammen eine beispielsweise monolithisch integrierte Schaltungsanordnung, die vollständig in dem Gehäuse 30 angeordnet ist.

Angenommen sei nunmehr, dass die Offsetspannung des Operationsverstärkers 10, welche im Mikrovoltbereich liegen kann, gemessen werden soll. Hierzu wird ein Messgerät an die Pins 24 und 26 des Gehäuses 30 angeschlossen. Infolge der unterschiedlichen Materialien der Pins und der Anschlusselemente des Messgeräts treten an den Pins Kontaktspannungen im Mikrovoltbereich auf. Da die Kontaktsspannungen im Bereich der zu messenden Offsetspannung liegt, können herkömmliche Operationsverstärker hoher Präzision über von außen angelegte Testmittel nicht genügend präzise getestet werden.

Damit die Offsetspannung des Operationsverstärkers 10 dennoch gemessen werden kann, ist das integrierte Gegenkopplungsnetzwerk 40 vorgesehen. Das Gegenkopplungsnetzwerk 40 sorgt dafür, dass die zwischen dem nicht invertierenden Eingang 14 und dem invertierenden Eingang 12 liegende Spannungsdifferenz durch den Gegenkopplungsfaktor von beispielsweise 10⁶ verstärkt wird. Die beim Anlegen des Messgerätes auftretenden Kontaktspannungen, welche am Ausgangspin 26 und am Eingangspin 24 auftreten, werden bei der dargestellten Schaltungsanordnung jedoch nicht mit dem Gegenkopplungsfaktor verstärkt. Mit anderen Worten werden dank des integrierten Gegenkopplungsnetzwerks 40 die Kontaktspannungen gegenüber der zu messenden Offsetspannung um 120dB unterdrückt. Dadurch ermöglicht die vorliegende monolithisch integrierte Verstärker-Schaltungsanordnung auch das Testen von Hochleistungs-Operationsverstärkern mit Offsetspannungen im Mikrovoltbereich.

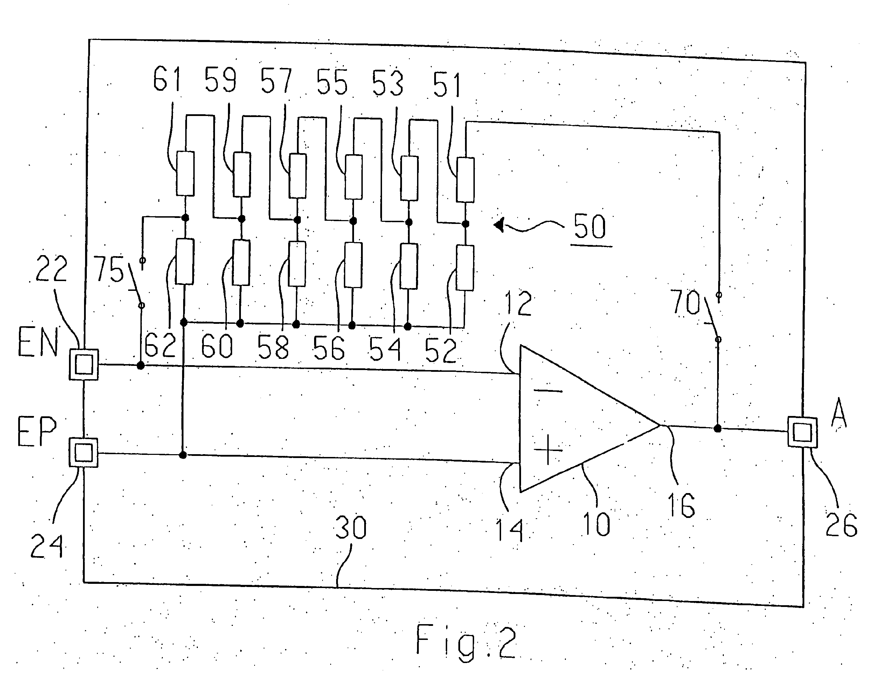

Ein kostengünstigeres Ausführungsbeispiel ist in Fig. 2 dargestellt. Soweit die beiden in den Figuren 1 und 2 dargestellten Ausführungsbeispiele gleiche Elemente verwenden, werden auch dieselben Bezugszeichen benutzt.

Die beispielhafte Verstärker-Schaltungsanordnung weist wiederum einen an sich bekannten Operationsverstärker 10 auf, der einen nicht invertierenden Eingang 14, einen invertierenden Eingang 12 sowie einen Ausgang 16 aufweist. Der Operationsverstärker 10 ist wiederum in einem Gehäuse, beispielsweise einem Dual-Inline-Gehäuse 30 angeordnet. Der invertierende Eingang 12 des Operationsverstärkers 10 ist mit einem Eingangspin 22 verbunden, der nicht invertierende 14 des Operationsverstärkers ist mit einem Eingangspin 24 des Gehäuses verbunden, und der Ausgang 16 des Operationsverstärkers mit einem Ausgangspin 26 des Gehäuses 30 verbunden ist.

Als Gegenkopplungsnetzwerk 50 wird bei dieser Ausführungsvariante eine mehrstufige, hintereinander geschaltete, das heißt kaskadierte Spannungsteileranordnung verwendet. Im vorliegenden Beispiel bilden sechs Spannungsteiler das Gegenkopplungsnetzwerk 50. Widerstände 51 und 52 bilden den ersten Spannungsteiler; Widerstände 53 und 54 bilden den zweiten Spannungsteiler, Widerstände 55 und 56 bilden den dritten Spannungsteiler, Widerstände 57 und 58 bilden den vierten Spannungsteiler, Widerstände 59 und 60 bilden den fünften Spannungsteiler, und Widerstände 61 und 62 bilden den sechsten Spannungsteiler. Angemerkt sei, dass die dargestellten Widerstände lediglich Symbolcharakter haben. Vielmehr umfasst bei einer beispielhaften realistischen Schaltungsanordnung jeder dargestellte Widerstand drei bis vier einzelne Widerstände. Die Widerstände sind derart dimensioniert, dass beispielsweise wieder ein Gegenkopplungsfaktor von 10⁶ erreicht wird.

Der erste, die beiden Widerstände 51 und 52 umfassende Spannungsteiler ist zwischen den nicht invertierenden Eingang 14 und den Ausgang 16 des Operationsverstärkers 10 geschaltet. Der zweite, die Widerstände 53 und 54 umfassende Spannungsteiler ist zwischen den Widerständen 51 und 52 des ersten Spannungsteilers und dem nicht invertierenden Eingang 14 geschaltet. Der dritte, die Widerstände 55 und 56 umfassende Spannungsteiler ist zwischen den Widerständen 53 und 54 und dem nicht invertierenden Eingang 14 geschaltet. Der vierte, die Widerstände 57 und 58 umfassende Spannungsteiler ist zwischen den Widerständen 55 und 56 und dem nicht invertierenden Eingang 14 geschaltet. Der fünfte, die Widerstände 59 und 60 umfassende Spannungsteiler ist zwischen den Widerständen 57 und 58 und dem nicht invertierenden. Eingang 14 des Operationsverstärkers 10 geschaltet. Der sechste Spannungsteiler, der die Widerstände 61 und 62 enthält, ist zwischen den Widerständen 59 und 60 sowie dem nicht invertierenden Eingang 14 geschaltet. Hierbei ist zu beachten, dass der Widerstand 62 direkt zwischen den nicht invertierenden Eingang 14 und den invertierenden Eingang 12 des Operationsverstärkers 10 geschaltet ist. Dadurch wird sichergestellt, dass lediglich die zwischen den beiden Eingängen 12 und 14 anliegende Spannungsdifferenz und nicht die an den Gehäusepins auftretenden Kontaktspannungen durch das Gegenkopplungsnetzwerk 50 verstärkt werden.

Ähnlich der in Fig. 1 dargestellten VerstärkerSchaltungsanordnung bildet das aus sechs hintereinander geschalteten Spannungsteiler aufgebaute Gegenkopplungsnetzwerk 50 zusammen mit dem Operationsverstärker 10 eine monolithisch integrierte Schaltungsanordnung, mit der auch in einer automatisierten Testumgebung die elektrischen Eigenschaften des Operationsverstärkers, insbesondere seine Offsetspannung gemessen werden kann. Denn das Gegenkopplungsnetzwerk 50 verstärkt lediglich die zwischen dem invertierenden Eingang 12 und dem nicht invertierenden Eingang 14 liegende Differenzspannung und nicht die an den Pins 24 und 26 auftretenden Kontaktspannungen, die beim Anlegen eines Messgerätes entstehen.

Das schematisch aus den Widerständen 51 bis 62 aufgebaute Gegenkopplungsnetzwerk 50 ist symbolisch durch zwei Schalter 70 und 75 mit dem Ausgang 16 beziehungsweise dem invertierenden Eingang 12 verbunden. Die Schalter 70 und 75 können durch eine nicht dargestellte Steuereinrichtung derart angesteuert werden, dass lediglich während des Testbetriebes das Gegenkopplungsnetzwerk 50 in den Gegenkopplungszweig des Operationsverstärkers 10 geschaltet wird.

Die Testprozedur, die mit dem Operationsverstärker 10 durchgeführt werden kann, dient beispielsweise dem Messen der Offsetspannung, der Gleichtaktunterdrückung und der Betriebsspannungsunterdrückung. Wie diese einzelnen Testprozeduren hinsichtlich eines Operationsverstärkers durchzuführen sind, sind dem Fachmann hinlänglich bekannt und werden demzufolge nicht näher erläutert.

## Patentansprüche

1. Integrierte Schaltungsanordnung mit
wenigstens einem Operationsverstärker (10), dessen Offsetspannungen im Bereich von Kontaktspannungen im Mikrovoltbereich liegen, und einem dem Operationsverstärker (10) zugeordneten Gegenkopplungsnetzwerk (40; 50), welches während eines Testbetriebs des Operationsverstärkers zum Verstärken der Offsetspannung des Operationsverstärkers zuschaltbar ist.

2. Integrierte Schaltungsanordnung nach Anspruch 1,
**dadurch gekennzeichnet, dass**
das Gegenkopplungsnetzwerk (40) einen Spannungsteiler (42, 44) umfasst.

3. Integrierte Schaltungsanordnung nach Anspruch 1,
**dadurch gekennzeichnet, dass**
das Gegenkopplungsnetzwerk (50) mehrere hintereinander geschaltete Spannungsteiler (51, 52 bis 61, 62) umfasst.

4. Integrierte Schaltungsanordnung nach einem der vorgenannten Ansprüche,
**dadurch gekennzeichnet, dass**
das Gegenkopplunganetzwerk (40, 50) und der Operationsverstärker (10) in einem Gehäuse (30) untergebracht sind.

## Claims

1. Integrated circuit arrangement having at least one operational amplifier (10), the offset voltages of which are in the range of contact voltages in the microvolt range, and having a negative feedback network (40; 50) which is allocated to the operational amplifier (10) and which, during a test operation of the operational amplifier, can be switched on to amplify the offset voltage of the operational amplifier.

2. Integrated circuit arrangement as claimed in claim 1, **characterised in that** the negative feedback network (40) comprises a voltage divider (42, 44).

3. Integrated circuit arrangement as claimed in claim 1, **characterised in that** the negative feedback network (50) comprises a plurality of voltage dividers (51, 52 to 61, 62) connected one behind the other.

4. Integrated circuit arrangement as claimed in any one of the preceding claims, **characterised in that** the negative feedback network (40, 50) and the operational amplifier (10) are accommodated in a housing (30).

## Revendications

1. Agencement de circuit intégré comprenant au moins un amplificateur opérationnel (10), dont les tensions offset dans la zone de tensions de contact sont de l'ordre du microvolt, et un réseau de contre-couplage (40 ; 50) attribué à l'amplificateur opérationnel (10), lequel réseau peut être mis sous tension pendant un fonctionnement de test de l'amplificateur opérationnel pour le renforcement de la tension offset de l'amplificateur opérationnel.

2. Agencement de circuit intégré selon la revendication 1,
**caractérisé en ce que**
le réseau de contre-couplage (40) comprend un diviseur de tension (42, 44).

3. Agencement de circuit intégré selon la revendication 1,
**caractérisé en ce que**
le réseau de contre-couplage (50) comprend plusieurs diviseurs de tension (51, 52 à 61, 62) montés les uns derrière les autres.

4. Agencement de circuit intégré selon l'une des revendications précédentes,
**caractérisé en ce que**
le réseau de contre-couplage (40, 50) et l'amplificateur opérationnel (10) sont logés dans un boîtier (30).
